# EUROPEAN PATENT APPLICATION

(11) **EP 4 648 574 A1**
(43) Date of publication of application: **12.11.2025**
(21) Application number: 25171237.8
(22) Date of filing: 17.04.2025
(51) Int. Cl.: H10B 41/47, H10B 41/30, H10B 41/35, H10D 30/01, H10D 30/68, H10B 41/10, H01L 21/762

(54) **NON-VOLATILE MEMORY CELL WITH SINGLE POLY FLOATING GATE AND CONTACT CONTROL GATE**

(30) Priority: 10.05.2024 US 202418661152
(71) Applicant: STMicroelectronics International N.V., 1228 Plan-les-Ouates, Geneva (CH)
(72) Inventor: BREGOLI, Roberto, 25020 OFFLAGA (BS) (IT); LANZI, Alberto, 25074 LAVENONE (BS) (IT); CARACE, Fausto, 20900 MONZA (MB) (IT); ATZENI, Laura, 20007 CORNAREDO (MI) (IT)
(74) Representative: Studio Torta S.p.A.

(57) **Abstract**

A cost-effective solution to implement a non-volatile memory cell (100) based on floating gate transistor (T1) including a floating gate (112) that overlies an active region (106) and a field region (105, 108) of a semiconductor substrate (104): Single Poly Floating Gate NVM bitcell. The control gate terminal is made at least in part of a metallic material and it is implemented with contact plug/s (Contact Control Gate) or metal field plate (152) separated by the floating gate using commonly present in CMOS process silicide protection dielectric layer SIPROT stack (oxide(s) and nitride(s)).

## Description

### BACKGROUND

### Technical Field

This present disclosure is related to non-volatile memory, and, more particularly, to a sing poly floating gate electrically erasable programmable read-only memory (EEPROM).

### Description of the Related Art

In smart power technologies, a solution for integration of low-cost memory is the single poly floating gate EEPROM. In one possible solution, the floating gate can be integrated with the same polysilicon used for CMOS and power MOS transistors. The tunnel oxide can also be the same used for CMOS and power MOS transistors. The control gate can be a well/diffusion in the substrate.

However, such a solution suffers from several drawbacks. For example, such a solution may call for a relatively high voltage to be applied between the control gate well and the body of the sense transistor for erase and/or program operations. This may in turn call for utilization of a significant area to sustain the voltage drop inside the semiconductor to avoid junction breakdown. This can impact the overall bit cell size. Furthermore, another possible high contribution to area consumption is the use of a silicon protection mask in the CMOS technologies. This process step can be utilized to isolate the floating gate from a borderless nitride layer, which can cause charged loss from the floating gate with consequent impact on retention properties. The usage of such masks layers increases the bit cell size since dedicated distance from the floating gate to drain/source contacts are allocated.

One possible solution to these issues is the use of hot electrons and hot hole injection to lower program and/or erase voltages. A possible solution can include constructing a nonvolatile memory bit cells with ad hoc process steps in order to reduce bit cell area. However, using the hot electrons on hot hole injection can increase power consumption, since only a small fraction of the current is effectively injected into the floating gate. Even if lower voltages are used, some spaces still wasted to sustain the voltage drop. Using hole injection also reduces the number of cycles before excessive program window narrowing happens (e.g., charge trapping). An ad hoc approach results in higher costs due to the introduction of additional masks and process steps.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventor's approach to the particular problem, which, in and of itself, may also be inventive.

### BRIEF SUMMARY

The present invention is set out in the annexed claims.

Embodiments of the present disclosure provide a nonvolatile memory cell and a corresponding method of manufacturing a nonvolatile memory cell that overcome at least some of the drawbacks above. Embodiments of the present disclosure provide a nonvolatile memory cell including a floating gate transistor and a selection transistor. Embodiments of the present disclosure advantageously utilize a silicide protection dielectric layer as the capacitive coupling dielectric of the control gate and floating gate of the floating gate transistor. Embodiments of the present disclosure utilize a control gate contact that at least partially overlies the field dielectric region outside of the active region of the substrate.

In one embodiment, the nonvolatile memory cell utilizes first and second distinct control gate contacts that overlies the polysilicon floating gate. The first control gate contact is positioned at least partially on a first lateral side of the active region. The second control gate contact is positioned at least partially on a second lateral side of the active region opposite the first lateral side. In one embodiment, the first and second control gate contacts do not overlap the active region or, in other words, are staggered with respect to the active region.

In one embodiment, the nonvolatile memory cell utilizes a field plate metal as a control gate contact. The field plate metal is positioned on the silicide protection dielectric layer and at least partially overlaps the field oxide region outside of the active region.

In one embodiment, a memory device includes a semiconductor substrate including an active region and a field region. The memory device includes a floating gate, a control gate above the floating gate, and a dielectric layer interposed between the control gate and the floating gate. The control gate is made at least in part of a metallic material.

In one embodiment, a memory device includes a semiconductor substrate including an active region and a field region. The memory device includes a floating gate, a control gate above the floating gate, and a dielectric layer interposed between the control gate and the floating gate. The control gate includes a plurality of discrete elements.

In one embodiment, a memory device includes a semiconductor substrate including an active region and a field region. The memory device includes a floating gate overlying the active region and the field region, a control gate arranged above the floating gate, and a dielectric layer interposed between the control gate and the floating gate. The control gate overlays the field region without overlapping the active region.

In one embodiment, a method includes forming a floating gate of a floating gate transistor of a memory cell overlying an active region and a field region of semiconductor substrate and forming a gate terminal of a selection transistor of the memory cell overlying the active region and the field region of the semiconductor substrate. The floating gate and the gate terminal have a same material. The method includes forming a dielectric layer over the floating gate and the gate terminal and forming a window in the dielectric layer exposing the gate terminal. The method includes forming a control gate of the floating gate transistor on the dielectric layer over the floating gate and forming a gate contact in contact with the gate terminal in the opening.

In one embodiment, a method includes reading data from a non-volatile memory cell including a floating gate transistor including a floating gate overlying an active region and a field region of a semiconductor substrate. Reading data includes applying a read body voltage to the field region and applying a read control gate voltage to a control gate positioned on a dielectric layer. The dielectric layer is positioned on the floating gate, the control gate overlying the field region. The method includes sensing a current responsive to the read control gate voltage.

### BRIEF DESCRIPTION OF THE SEVERAL VIEWS OF THE DRAWINGS

Figure 1A is a perspective view of an integrated circuit including a nonvolatile memory cell, in accordance with one embodiment.
Figure 1B is a circuit diagram of the non-volatile memory cell, in accordance with one embodiment.
Figure 2 is a sectional perspective view of an integrated circuit including a nonvolatile title memory cell, in accordance with one embodiment.
Figure 3 is a sectional perspective view of an integrated circuit including a nonvolatile memory cell, in accordance with one embodiment.
Figure 4 is a perspective view of an integrated circuit including a nonvolatile memory cell, in accordance with one embodiment.
Figure 5 is a cross-sectional view of an integrated circuit including a nonvolatile memory cell, in accordance with one embodiment.
Figure 6 is a top view layout of a portion of a nonvolatile memory cell, in accordance with one embodiment.
Figure 7A is a top view layout of a nonvolatile memory array, in accordance with one embodiment.
Figure 7B is an enlarged view of the layout of a memory cell of the memory array of Figure 7A including a superimposed circuit diagram of the memory cell, in accordance with one embodiment.
Figure 7C is a top view layout of a nonvolatile memory array including wordlines, bitlines, and selection lines, in accordance with one embodiment.
Figure 8 is a top view layout of a nonvolatile memory array, in accordance with one embodiment.
Figure 9 is a cross-sectional view of a nonvolatile memory cell, in accordance with one embodiment.
Figure 10 is a flow diagram of a method for manufacturing a nonvolatile memory array, in accordance with one embodiment.

### DETAILED DESCRIPTION

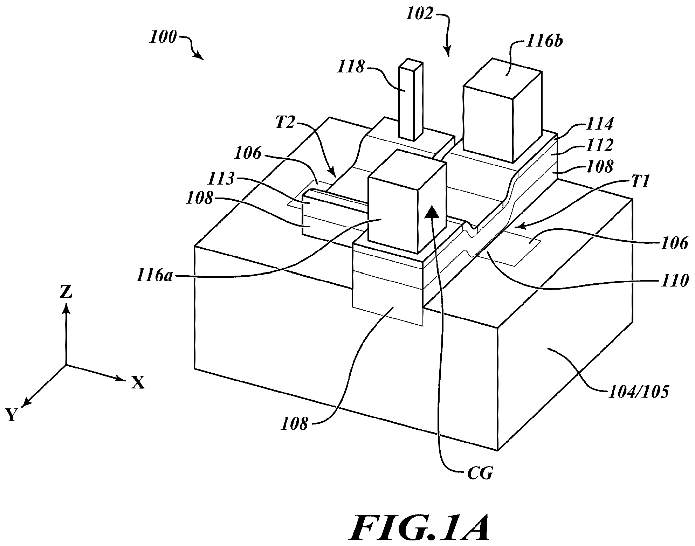

Figure 1A is perspective view of an integrated circuit 100, including a non-volatile memory cell 102, in accordance with one embodiment. The nonvolatile memory cell 102 is a floating gate memory cell includes a floating gate transistor T1 and a CMOS selection transistor T2. As will be set forth in more detail below, the nonvolatile memory cell includes a control gate including multiple control gate contacts capacitively coupled to the floating gate of the floating gate transistor T1. The multiple control gate contacts are formed at least partially outside of the active region of the floating gate transistor T1. The integrated circuit 100 is, in some embodiments, termed a memory device.

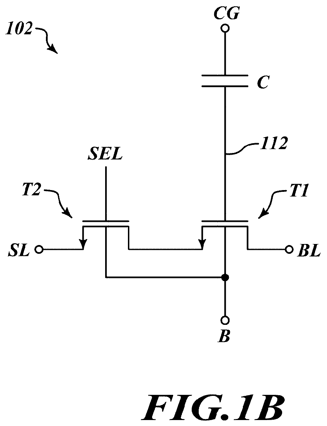

Prior to further description of the integrated circuit 100 of Figure 1A, it is beneficial to describe the circuit layout of the nonvolatile memory cell 102. Figure 1B is a circuit diagram of the nonvolatile memory cell 102 of Figure 1A, in accordance with one embodiment.

With reference to Figure 1B, the nonvolatile memory cell 102 includes the floating gate transistor T1, the selection transistor T2, and a capacitor C. A first terminal of the capacitor C is a control gate CG of the memory cell 102. A second terminal of the capacitor C is the floating gate 112 of the floating gate transistor T1. The drain terminal of the floating gate transistor T1 is coupled to a bitline BL. The source terminal of the floating gate transistor T1 is coupled to a drain terminal of the selection transistor T2. The gate terminal of the selection transistor T2 receives the selection signal SEL. The source terminal of the transistor T2 is coupled to a source line SL. The body terminals of the transistors T1 and T2 receives a body voltage B. The bitline BL is, in some embodiments, termed a drain bitline BLD. The source line SL is also termed, in corresponding embodiments, a source bitline BLS.

In general, the nonvolatile memory cell 102 can be programmed, erased, and read by applying selected voltages to the control gate CG, the bitline BL, the gate terminal of the transistor T2, and the body terminals. The floating gate 112 of the transistor T1 corresponds to a data storage element of the nonvolatile memory cell 102. Data can be stored in the floating gate when a tunneling current causes charges to be stored in or removed from the floating gate 112, depending on the specific configuration of the memory cell 102. The nonvolatile memory cell 102 can be erased in a similar manner by a tunneling current that either stores charges in or removes charges from the floating gate 112, depending on the configuration of the nonvolatile memory cell 102. The nonvolatile memory cell 102 can be read by applying read voltages to the control gate CG, the bitline BL, and the gate of the transistor T2 and then sensing a current (or lack of current) flowing through the transistors T1 and T2. Further details regarding read, program, and erase operations of the nonvolatile memory cell 102 will be described further below.

Returning to Figure 1A, the integrated circuit 100 includes a substrate 104. The substrate 104 can include a semiconductor material. In one embodiment, the semiconductor material of the substrate 104 includes silicon. Alternatively, other semiconductor materials can be utilized, including, but not limited to germanium; a compound semiconductor including silicon carbide, gallium arsenide, gallium phosphide, indium phosphide, indium arsenide, and/or indium antimonide; an alloy semiconductor including silicon-germanium, gallium arsenide phosphide, aluminum indium arsenide, aluminum gallium arsenide, gallium indium arsenide, gallium indium phosphide, and/or gallium indium arsenide phosphide; or combinations thereof. Other substrates, such as single-layer, multi-layered, or gradient substrates may be used.

In one embodiment, the substrate 104 below the transistors T1 and T2 includes a doped body region 105. In one embodiment, the doped body region is a P-well. The P-well can correspond to a semiconductor material doped with P-type dopants such as boron or another suitable dopant. The dopant concentration of the P-well can be between 1E14/cm^3 and 1E18/cm^3, though other values can be utilized without departing from the scope of the present disclosure.

In one embodiment, the P-well extends from a top surface of the substrate 104 to a bottom surface of the substrate 104. Alternatively, the P-well can extend from a top surface of the substrate 104 to a selected depth within the substrate 104.

In one embodiment, the P-well corresponds to the body of the transistors T1 and T2. Though not shown in Figure 1A, the integrated circuit 104 includes one or more body contacts by which a selected body voltage can be applied to the P-well of the body region 105 as part of read, program, and erase operations of the nonvolatile memory cell 102. While the description focuses primarily on embodiments in which the body region of the transistors of the nonvolatile memory cell 102 is a P-well, in other embodiments the body of the nonvolatile title memory cell 102 includes an N-well.

The substrate 104 includes an active region 106. The active region 106 corresponds to a portion of the substrate 104 that includes the source, drain, and channel regions of the transistors T1 and T2. The active region may correspond to an active diffusion area, commonly termed "OD".

In one embodiment, the active region 106 corresponds to an N-well embedded within the P-well of the body region 105. The N-well extends from the top surface of the substrate 106 to a selected distance within the P-well. The N-well can correspond to a semiconductor material doped with N-type dopants such as phosphorus, arsenic, or other suitable N-type dopants. The N-well of the active region 106 can extend continuously below the transistors T1 and T2.

In one embodiment, the integrated circuit 100 includes a field dielectric region 108 (e.g., a field oxide regions) extending into the substrate 104. A portion of the field dielectric region is above the substrate 104 and a portion of the field dielectric region 108 is below the substrate 104. In one embodiment, the field dielectric region 108 corresponds to a shallow trench isolation (STI) region. The field dielectric region 108 includes a dielectric material. In an exemplary embodiment, the dielectric material includes silicon oxide, such as SiO2. However, the dielectric material can include SiN, SiCN, SiOC, SiOCN, or other dielectric materials without departing from the scope of the present disclosure.

In one embodiment, the portions of the body region 105 outside of the active region 106 correspond to a field region of the substrate 104. The field region includes portions of the body region 105 that are below the field dielectric region 108.

The integrated circuit 100 includes a gate dielectric layer 110. The gate dielectric 110 layer corresponds to a thin layer of dielectric material directly over a channel region of the transistors T1 and T2. In an exemplary embodiment, the gate dielectric layer 110 includes silicon oxide. However, the gate dielectric layer 110 can include HfO₂, HfSiO, HfSiON, HfTaO, HfTiO, HfZrO, zirconium oxide, aluminum oxide, titanium oxide, hafnium dioxide-alumina (HfO₂-Al₂O₃) alloy, other suitable dielectric materials.

Though not apparent in the view of Figure 1A, the gate dielectric 110 can include a first portion directly over the channel region of the floating gate transistor T1 and a second portion directly over the channel region of the selection transistor T2. The first portion and the second portion are separated from each other. The channel region of the transistor T1 corresponds to the upper portion of the active region 106 directly below the floating gate 112 of the floating gate transistor T1. The channel region of the transistor T2 corresponds to the upper portion of the active region 106 directly below the gate terminal 113 of the selection transistor T2. The gate dielectric 110 can be of a same material as the field dielectric 108. The gate dielectric 110 can be contiguous with the field dielectric 108.

The integrated circuit 100 includes a layer of polysilicon for the floating gate 112 of the floating gate transistor T1 and the gate terminal 113 of the selection transistor T2. Accordingly, the floating gate terminal 112 of the floating gate transistor T1 and the gate terminal 113 of the selection transistor T2 correspond to a same layer of polysilicon. While the description primarily describes embodiments in which the floating gate 112 and the gate terminal 113 are polysilicon, other gate materials can be utilized without departing from the scope of the present disclosure.

The floating gate 112 is positioned on the field dielectric 108 and the gate dielectric 110. The floating gate 112 extends in the Y direction on the field dielectric 108, on the gate dielectric 110 across the active region 106, and on the field dielectric 108 on the other side of the active region 106. In one embodiment, the floating gate 112 extends far enough in the Y direction on either side of the active region 106 to enable separate control gate contacts to be positioned directly over the floating gate on each side of the active region 106 as will be described in further detail below.

In one embodiment, the floating gate transistor T1 includes a silicide protection (SIPROT) dielectric layer 114. The silicide protection dielectric layer 114 is utilized as a capacitive coupling for the floating gate 112. In other words, the silicide protection layer 114 is the dielectric material between the first terminal (CG) of the capacitor C and the second terminal (floating gate 112) of the capacitor C. Prior to providing further description of the silicide protection dielectric layer 114, it is beneficial to describe aspects of the selection transistor T2.

The selection transistor T2 includes a polysilicon gate terminal 113. A gate contact 118 is directly coupled to the gate terminal 113 of the selection transistor T2. The gate contact 118 corresponds to a metal structure such as a conductive plug or conductive via by which a voltage can be applied to the gate terminal 113. In other words, the selection signal SEL is provided to the gate terminal 113 via the gate contact 118. The gate contact 118 can include one or more of tungsten, titanium, aluminum, titanium nitride, tantalum nitride, or other suitable conductive materials.

In order to provide a strong electrical connection between the gate terminal 113 of the gate contact 118, a silicide (not shown) is formed on the top surface of the gate terminal 113 of the selection transistor T2. The silicide can be formed by depositing a conductive metal such as titanium, nickel, or other suitable metals. A thermal annealing process can then be performed to form a silicide from the polysilicon and the metal at the interface of the polysilicon and the metal. The gate contact 118 can then subsequently be formed.

The silicon protection dielectric layer 114 is utilized to help ensure that no silicide is formed on the polysilicon of the floating gate 112 of the transistor T1. Accordingly, after deposition and patterning of the polysilicon to form the floating gate 112 and the gate terminal 113, the silicon protection dielectric layer 114 is formed over the surface of the integrated circuit 100.

Initially, the silicon protection dielectric layer 114 covers both the floating gate 112 and the gate terminal 113. The silicon protection dielectric layer 114 is then patterned to expose the polysilicon of the gate terminal 113 of the transistor T2, while covering the polysilicon of the floating gate 112. The metal for the previously described silicide can then be deposited on the gate terminal 113 and the silicide can be formed. Due to the presence of the silicide protection dielectric layer 114, no silicide is formed at the floating gate 112. The silicide protection dielectric layer 114 is termed, in some embodiments, a silicide protection mask.

In one embodiment, the silicide protection dielectric layer 114 includes a stack of dielectric layers. In one example, the silicide protection dielectric layer 114 includes a first layer of silicon oxide directly on the floating gate 112. The silicide protection dielectric layer 114 includes a second layer of tetraethyl orthosilicate (TEOS) on the first layer of silicon oxide. The silicon protection dielectric layer 114 includes a third layer of silicon nitride on the second layer of TEOS. Other layers and other combinations of layers can be utilized for the silicide protection dielectric layer 114 without departing from the scope of the present disclosure.

In one embodiment, the floating gate transistor T1 includes a first control gate contact 116a and the second control gate contact 116b. In other words, the control gate of the memory device comprises a plurality of discrete elements (i.e., the control gate contacts 116a/b).

The first and second control gate contacts 116a/b are formed on the silicon protection dielectric layer 114 directly above the floating gate 112. The control gate contacts 116a/b can be formed of a same material and in a same deposition process as the gate contact 118. Alternatively, the control gate contacts 116a/b can be formed of a different material than the gate contact 118.

In one embodiment, the control gate contacts 116a/b are formed on opposite sides of the active region 106 without overlapping the active region 106. The control gate contact 116a is formed on an opposite side of the active region 106 from the gate contact 118 of the transistor T2. The control gate contact 116b is formed on a same side of the active region 106 as the gate contact 118 of the transistor T2.

In one embodiment, one or both of the control gate contacts 116a/b overlap the active region 106. In other words one or both of the control gate contacts 116a/b can be formed partially over the active region 106 and partially over the field dielectric region 108.

The control gate contacts 116a/b correspond to a first terminal of the capacitor C of the nonvolatile memory cell 102. The floating gate 112 corresponds to a second terminal of the capacitor C of the nonvolatile memory cell 102. The silicide protection dielectric layer 114 corresponds to the dielectric of the capacitor C.

In one embodiment, the control gate contact 116a has a much larger area footprint than the control gate contact 116b. In one embodiment, the control gate contact 116a has an area footprint that is greater than or equal to 10 times the area footprint of the control gate contact 116b. In one embodiment, the control gate contact 116a has an area footprint that is greater than or equal to 100 times the area footprint of the control gate contact 116b.

As used herein, the term "active region" refers to locations where transistor channels, source, drain are defined, and may include regions where well ohmic contacts are formed. As used herein, the term "field region" refers to areas outside the active region, where a thick oxide or other dielectric is used for isolation among adjacent active areas.

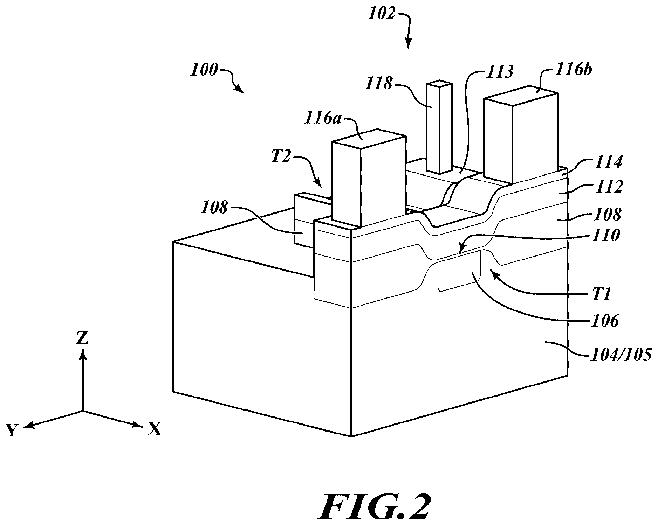

Figure 2 is a sectional perspective view of the integrated circuit 100 of Figure 1A, in accordance with one embodiment. The section is taken through the floating gate transistor T1. The sectional view of Figure 2 more clearly illustrates the thin gate dielectric layer 110 directly between the active region 106 and the floating gate 112.

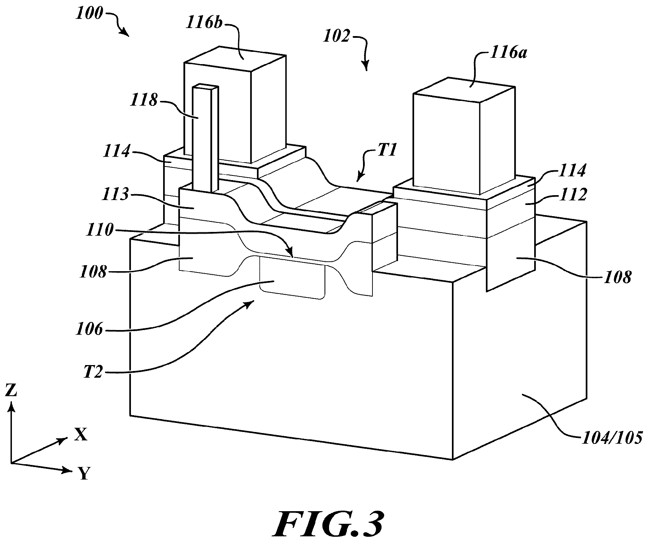

The view of Figure 3 further illustrates that the polysilicon of the control gate 113 extends further in the Y direction on one side of the active region 106 than on the other side of the active region 106. Figure 3 illustrates that the polysilicon of the floating gate 112 extends further in the Y direction on both sides of the active region 106 than does the polysilicon of the gate terminal 113 of the transistor T2. Furthermore, the polysilicon of the gate terminal of the transistor T2 is less wide in the X direction than is the polysilicon of the floating gate 112 of the floating gate transistor T1.

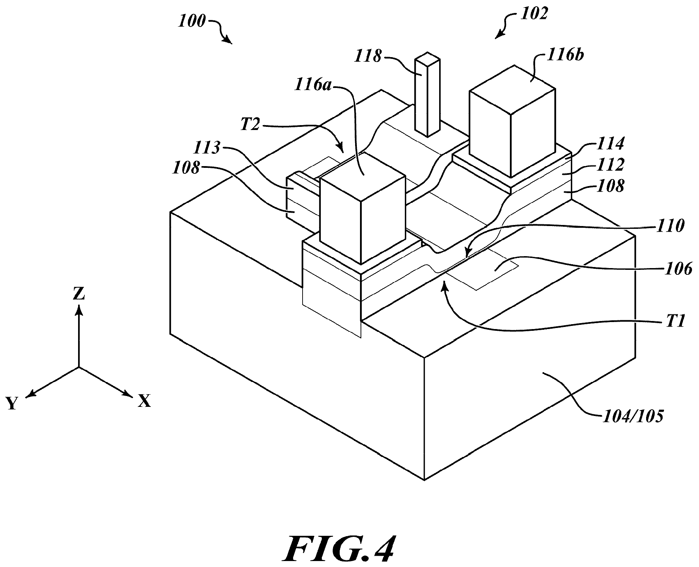

Figure 4 is a perspective view of an integrated circuit 100 including a nonvolatile title memory cell 102, in accordance with one embodiment. The nonvolatile memory cell 102 of Figure 4 is substantially similar to the nonvolatile memory cell 102 of Figure 1A. However, in the nonvolatile memory cell 102 of Figure 4 the silicide protection dielectric layer 114 is patterned so that it does not overlie the active region 106.

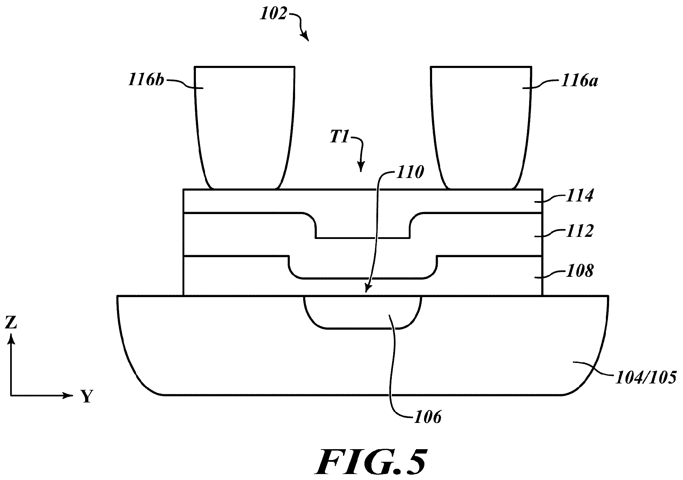

Figure 5 is a cross-sectional view of a floating gate transistor T1 of a nonvolatile memory cell 102, in accordance with one embodiment. The floating gate transistor T1 of Figure 5 is substantially similar to the floating gate transistor T1 of Figure 1A. The cross-sectional view illustrates the active region 106 embedded in the substrate 104/body 105. The thick field dielectric region 108 is on either side of the active region 106. The thin gate dielectric layer 110 is positioned directly over the active region 106. The floating gate 112 is positioned over the field dielectric region 108 and the gate dielectric 110. The silicide protection dielectric layer 114 is positioned over the floating gate 112. The silicide protection dielectric layer 114 has a planar top surface in Figure 5. The control gate contacts 116a/b are positioned directly on the silicide protection dielectric layer 114 over the floating gate 112 on either side of the active region 106 (not over the active region). The field region of the substrate 104 corresponds to portions of the substrate 104 below the field dielectric region 108 or otherwise to the sides of the active region 106.

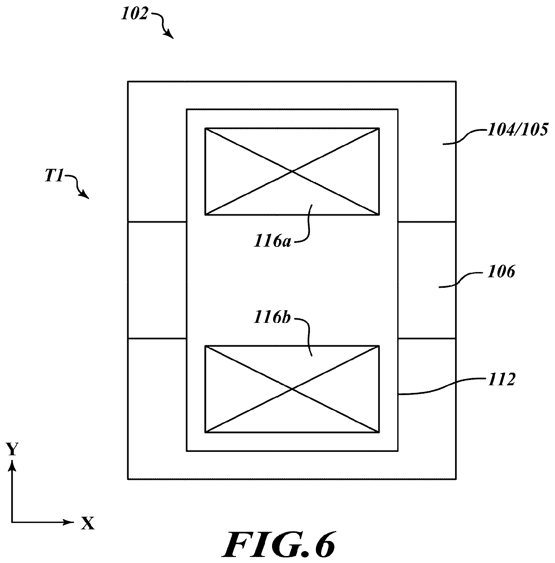

Figure 6 is a layout top view of a portion of a floating gate transistor T1 of a nonvolatile memory cell 102, in accordance with one embodiment. The top view illustrates the active region extending in the X direction in the substrate 104/body 105. The floating gate 112 overlies the active region 106 and the portion of the substrate 104/body 105 on either side of the active region 106. The control gate contacts 116a/b are formed on either side of the active region 106, without overlapping the active region 106; that is to say that the control gate contacts 116a/b are staggered with respect to the active region 106, more particularly the control gate contacts 116a/b are vertically staggered (wherein the vertical direction is along or parallel to the Z direction) with respect to the active region 106. However, as described previously, in one embodiment, one or both of the control gate contacts 116 at least partially overlap(s) the active region 106.

Returning to Figure 1B, a description of the read, program, and erase operations of the nonvolatile memory cell 102 will now be described, in accordance with one embodiment. When the memory cell 102 is to be read, the selection signal SEL is raised to a read voltage and the NMOS selection transistor T2. The body voltage (e.g., the P-well voltage) is set to ground. A bitline read voltage is applied to the bitline BL. A control gate read voltage is applied to the control gate (e.g., the control gate contacts 116a/b). If the floating gate 112 is in the erased condition, then the floating gate transistor T1 will be turned on and a current will flow through the transistors T1 and T2 between the bitline BL and the source line SL. A sense amplifier is connected to the bitline via a multiplexer (not shown). The sense amplifier senses the current and determines that the nonvolatile memory cell 102 is in the erased condition (e.g., data value 0).

If the floating gate is in the programmed condition (e.g., data value 1), then the floating gate transistor T1 will not turn on when the various read voltages are applied. The result is that a current will not flow through the transistors T1 and T2. The lack of current will be sensed by the sense amplifier and the memory cell 102 will be determined to be in the programmed condition.

In one embodiment, if the memory cell 102 is in a memory sector that has been selected for a read operation but is not coupled to a wordline that has been selected for a read operation in that sector, then the control gate signal will be at a read voltage of the selection signal SEL will be low (e.g. ground) and the transistor T2 will not turn on. The result is that no current will flow through the transistors T1 and T2 regardless of whether the memory cell 102 is in the erased condition or the programmed condition.

In one embodiment, if the memory cell 102 is in a memory sector that has not been selected for a read operation and is not coupled to a wordline that has been selected for a read operation, then the control gate signal will be at ground and the value of the selection signal SEL will be ground and the transistor T2 will not turn on. The result is that no current will flow through the transistors T1 and T2 regardless of whether the memory cell 102 is in the erased condition or the programmed condition.

In one embodiment, programming of the floating gate of volatile memory cell is accomplished via Fowler Nordheim (FN) tunneling. If the memory cell 102 is in a selected sector and the memory cell 102 is selected for programming, then a high programming voltage is applied to the control gate, the bitline BL is brought to ground, the body terminal is brought to ground, and the source line is brought to ground. The bitline BL is brought to ground through a programming path. The result is that a tunneling current flows from the floating gate 112 of the floating gate transistor T1. The tunneling current tunnels across the gate dielectric 110, thereby changing the net charge in the polysilicon floating gate 112. This corresponds to programming of the memory cell.

In one embodiment, an erase operation of the memory cell 102 includes hot hole injection with the floating gate 112. In one embodiment, a program of the memory cell 102 includes hot electron injection with the floating gate 112.

If the nonvolatile memory cell 102 is in a selected sector but the memory cell 102 is not selected for programming, then the control gate will be brought to the programming voltage, the body terminal is a ground, and the source line is a ground. The bitline is brought to a high voltage. In other words, the bitline is connected to a programming inhibit voltage through a programming path. The high voltage on the bitline BL prevents a tunneling current from flowing across the gate dielectric 110. The result is that the nonvolatile memory cell 102 is not programmed.

If the nonvolatile memory cell 102 is a non-selected wordline and is in a sector that is not selected for a programming operation, then the control gate, the source line, and the body B are all brought to ground. If the memory cell 102 is connected to a selected bitline, then the bitline is also brought to ground. No tunneling current flows of the cells are programmed. If the memory cell 102 is coupled to a non-selected bitline, then the non-selected bitline is brought to the programming inhibit voltage and no tunneling current flows.

In one embodiment, erasing of the memory cell occurs at the sector level. In other words, an entire sector of memory cells can be erased simultaneously. If the memory cell 102 is part of a selected sector for an erase operation, then the gate terminal of the selection transistor is brought to a high erase voltage. The control gate is brought to ground. The body terminal B is brought to a high erase voltage. The bitline BL and the source line SL are floating. The result is that a tunneling current tunnels from the body B across the gate dielectric 110 onto the polysilicon floating gate 112. This results in erasure of the memory cell 102.

In one embodiment, if the memory cell 102 is part of a non-selected sector during an erase operation, then the control gate will be brought to an erase inhibiting voltage. The other terminals are at the same voltages described for the selected sector. The result is that no tunneling current flows in the memory cell 102 is not erased.

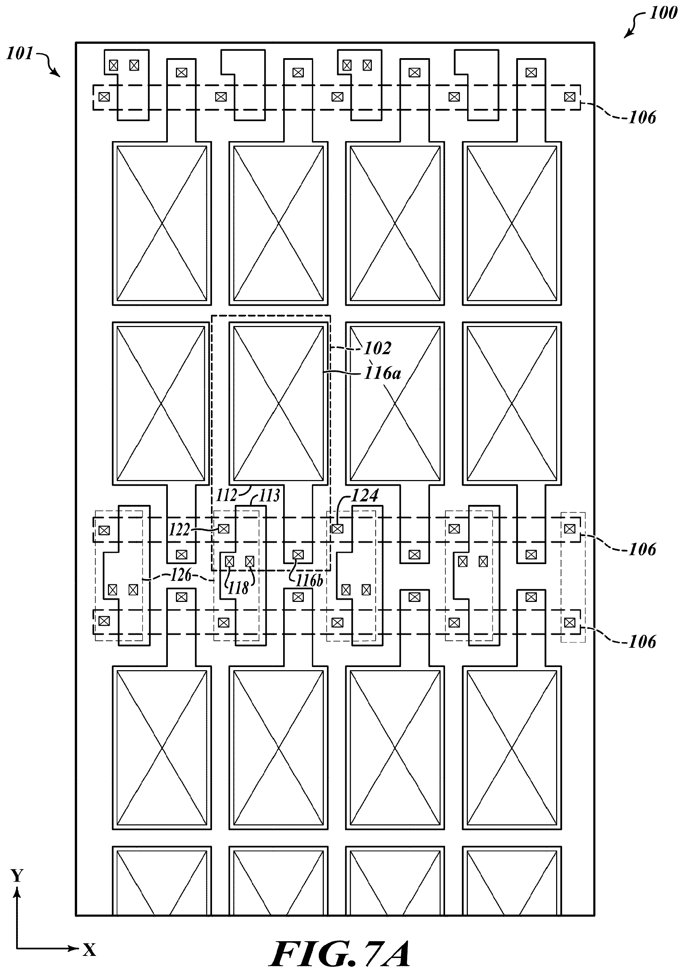

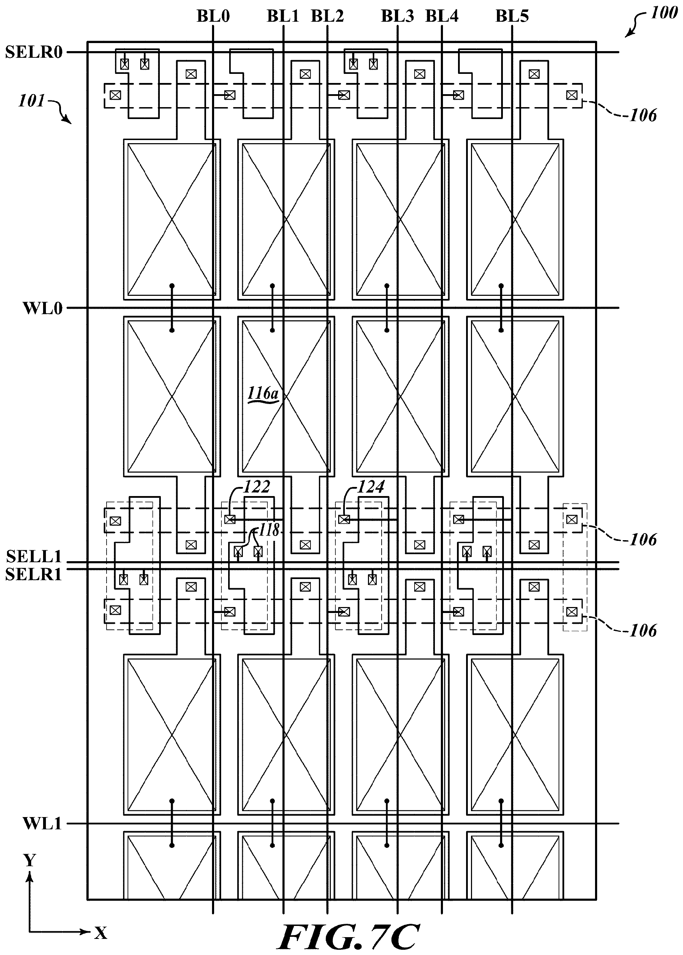

Figure 7A is a layout top view of an integrated circuit 100 including a nonvolatile memory array 101, in accordance with one embodiment. The memory array 101 includes a plurality of nonvolatile memory cells, such as the nonvolatile memory cell 102 shown in relation to Figures 1A-6. For simplicity in understanding the layout, wordlines, bitlines, and selection lines are not shown in Figure 7A. Instead, the wordlines, bitlines, and selection lines are shown in Figure 7C.

The view of Figure 7A illustrates a plurality of memory cells 102. However, only a single memory cell 102 and the corresponding contacts are detailed with reference numbers. The memory cell 102 for which detail is provided is surrounded by a dashed box indicating the area corresponding to the memory cell 102.

The memory cell is formed in conjunction with an active region 106 extending in the X direction. As three active regions 106 are shown in Figure 7A, the memory cell 102 for which detail is provided is formed in conjunction with the central active region 106. The polysilicon floating gate 112 has a first portion of a relatively large area on a first side of the active region 106. The first portion is covered by a first large area control gate contact 116a. This large area portion of the floating gate 112 and the control gate contact 116a provides a large capacitive coupling between the floating gate 112 and the control gate contact 116a.

The polysilicon floating gate 112 has a second portion on an opposite side of the active region 106. The second portion has a considerably smaller area than the first portion. A control gate contact 116b is formed over the second portion of the floating gate 112.

The polysilicon control gate 113 of the selection transistor T2 is also formed overlying active region 106. Two gate contacts 118 are formed over the control gate 113 on a same side of the active region 106. A source contact of the selection transistor T2 contacts the active region 106 to the left of the control gate 113. A drain contact of the floating gate transistor 112 contacts the active region 106 to the right of the floating gate 112.

The view of Figure 7A also illustrates windows 126 the market by dashed boxes. The windows 126 correspond to areas at which the silicide protection dielectric layer 114 is not present. Accordingly, the gate contacts 118 directly contact the polysilicon gate 113 in a window 126. The previously described silicide is formed at this location because the silicide protection dielectric layer 114 is not present.

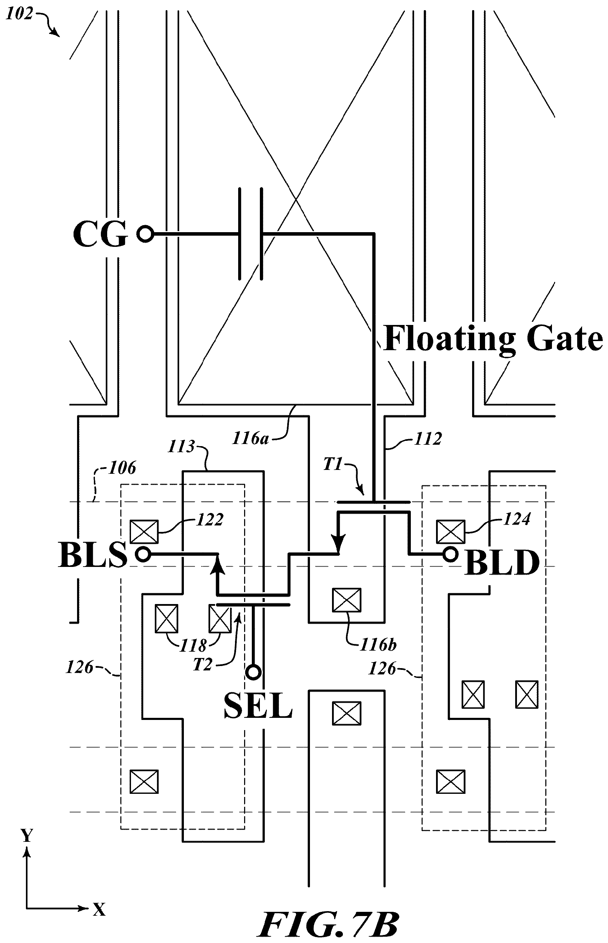

Figure 7B is an enlarged view of a portion of the layout of Figure 7A, in accordance with one embodiment. Or particularly, Figure 7B is an enlarged view of the portion of the layout corresponding to the nonvolatile memory cell 102 that was detailed in relation to Figure 7A. Figure 7B also includes a circuit diagram representation of the memory cell 102 superimposed onto the layout view.

The view of Figure 7B helps to illustrate more clearly that the capacitor C corresponds, primarily, to the large area of the floating gate 112 over which the control gate contact 116a formed. The view of Figure 7B also helps to illustrate the layout portions corresponding to source, drain, and gate contacts of the memory cell 102.

Figure 7C corresponds to the view of Figure 7A, but with the bitlines BL the selection lines SEL, and the wordlines WL present, in accordance with one embodiment. Each wordline WL is connected to the control gate contact 116a of eight memory cells. The wordline WL0 is connected to the control gate contact 116a of the memory cell 102 for which detail has been provided in Figures 7A and 7B. Each control gate identifies a wordline WL and the sector. In Figure 7C, two wordlines WL are shown.

In one embodiment, the memory array 101 corresponds to virtual NOR architecture in which to consecutive memory cells that share the same bitline BL, which is a drain line for one cell and a source line for the other cell. The bitline BL3 is coupled to the drain contact 124 of the memory cell 102 for which detail was provided in Figures 7A and 7B. The bitline BL1 is coupled to the source contact 122 of the selection transistor T2 corresponds to the source line of the selection transistor T2 for which detail was provided in Figures 7A and 7B.

Each select line SEL is connected to the gate contacts 118 of a plurality of memory cells 102. Memory cells that share the same select line SEL have different bitlines BL. This enables having the current contribution from a single cell during a read operation, even in the case of depleted cells. The select line SELL1 is connected to the gate contacts 118 of the selection transistor T2 of the memory cell 102 for which detail was provided in Figures 7A and 7B.

In one embodiment, a non-volatile memory bit cell in accordance with principles of the present disclosure can be implemented without a selection transistor. In this case, the configuration of the memory array 101 can be changed from a virtual NOR arrangement to a NOR arrangement.

Other layouts and configurations of a memory array 101 and the memory cells 102 can be utilized in conjunction with principles of the present disclosure without departing from the scope of the present disclosure.

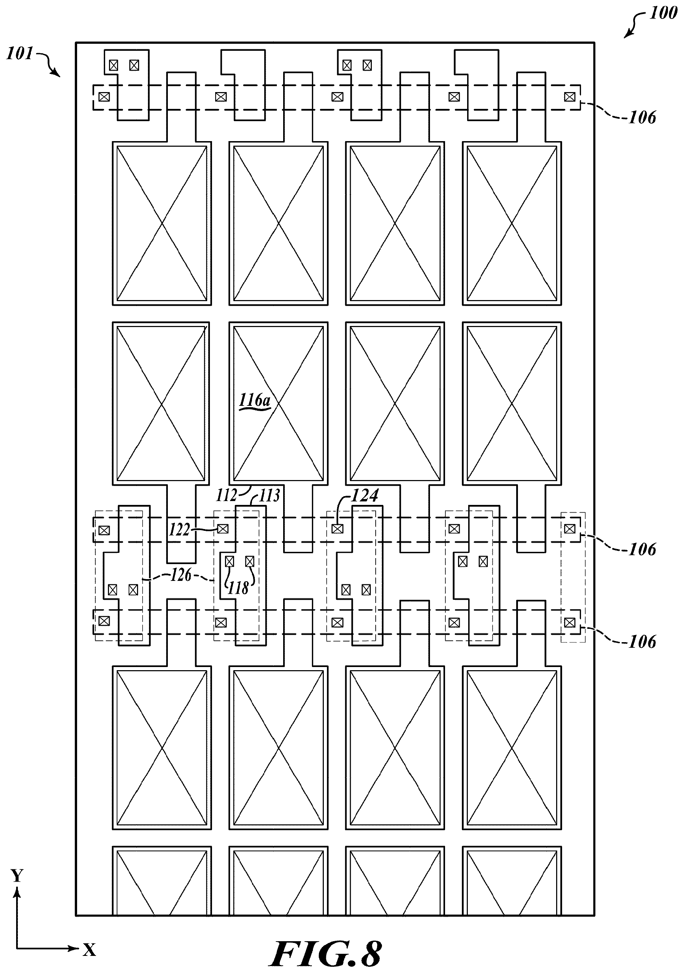

Figure 8 is a top view layout of a memory array 101 including a plurality of memory cells 102, in accordance with one embodiment. The layout of the memory array 101 of Figure 8 is substantially similar to the layout of the memory array 101 of Figure 7A, except that the control gate contacts 116b is not present in Figure 8. Other variations can be utilized without departing from the scope of the present disclosure.

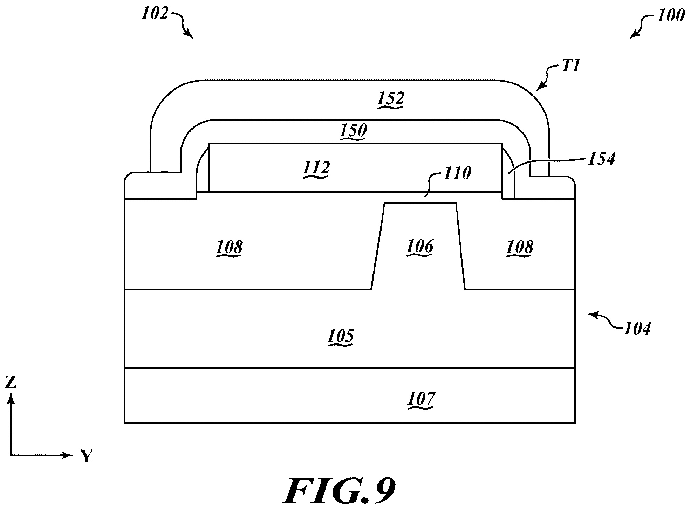

Figure 9 is a cross-sectional view of an integrated circuit 100 including a floating gate transistor T1 of a nonvolatile memory cell 102, in accordance with one embodiment.

In Figure 9, only the floating gate transistor T1 is shown. However, memory cell 102 can include the selection transistor T2 and other connections as described in relation to Figures 1A-7C.

The integrated circuit 100 includes a substrate 104. The substrate 104 corresponds to a semiconductor substrate and can include semiconductor material such as those described in relation to the substrate 104 of Figure 1A.

The substrate 104 includes a body region 105. In one embodiment, the body region 105 is a P-well region. In other words, the body region 105 is a well region doped with P-type dopant species.

In one embodiment, the substrate 104 includes a deep well region 107. In one embodiment, the deep well region 107 is an N-well region below the body region 105. The N-well region is doped with N-type dopants species.

In one embodiment, the substrate 104 includes an active region 106. The active region 106 corresponds to a region in which source, drain, and channel regions of the transistors T1 and T2 are formed. The active region 106 extends in the X direction. In one embodiment, the active region 106 is an upward extension of the body region 105. In one embodiment, the active region 106 is doped with P-type dopants.

In one embodiment, the integrated circuit 100 includes field dielectric regions 108 on each side of the active region 106. The field dielectric regions 108 can include the materials and properties described in relation to the field dielectric regions 108 of Figure 1A. The field dielectric regions 108 can correspond to shallow trench isolation regions.

In one embodiment, the floating gate transistor T1 includes a gate dielectric layer 110. The gate dielectric layer 110 includes a very thin dielectric layer directly over the active region 106. The gate dielectric layer 110 can include the materials and properties described in relation to the gate dielectric layer 110 of Figure 1A. The gate dielectric layer 110 is contiguous with the field dielectric regions 108. The gate dielectric layer 110 can correspond to the same gate dielectric layer utilized for the CMOS transistors and power MOS transistors of the integrated circuit 100.

In one embodiment, the floating gate transistor T1 includes a polysilicon floating gate 112. The polysilicon floating gate 112 can include the materials and properties described in relation to the polysilicon floating gate 112 of Figure 1A.

In one embodiment, the transistor T1 includes dielectric sidewall spacers 154 formed on sidewalls of the polysilicon floating gate 112. The dielectric sidewall spacers 154 can include one or more of SiN, SiCN, SiOC, SiOCN, or other dielectric materials. The dielectric sidewall spacers 154 can include multiple layers of dielectric material.

In one embodiment, the transistor T1 includes a dielectric layer 150 on a top surface of the polysilicon floating gate 112. The dielectric layer 150 can include one or more of SiO2, SiN, SiCN, SiOC, SiOCN, or other dielectric materials. In one embodiment, the dielectric layer 150 is a silicide protection layer and has a composition substantially similar to the composition of the silicide protection layer 114 of Figure 1A. In one embodiment, the thickness of the dielectric layer 150 is about 80 nm. The composition of thickness of the dielectric layer 150 can be selected so that the dielectric layer 150 can also be utilized in conjunction with a power MOS transistor that can be implemented within the integrated circuit 100.

In one embodiment, the transistor T1 includes a metal field plate 152. The metal field plate 152 acts as a control gate contact for the nonvolatile memory cell 102. The metal field plate 152 corresponds to a first terminal of the capacitor C of the memory cell 102. The dielectric layer 150 acts as the dielectric of the capacitor C of the memory cell 102. The polysilicon floating gate 112 acts as the second terminal of the capacitor C of the memory cell 102.

In one embodiment, the metal field plate 152 overlies the field oxide regions 108 on either side of the active region 106. The metal field plate 152 also overlies the active region 106. The metal field plate 152 can completely cover the polysilicon floating gate 112. Alternatively, the metal field plate 152 can partially overlie the polysilicon floating gate 112. In other words, the control gate of the memory device comprises a single element (i.e., the metal field plate 152).

In one embodiment, the metal field plate 152 includes titanium nitride. Alternatively, the metal field plate 152 can include aluminum, titanium, tantalum, tungsten, tantalum nitride, or other suitable conductive materials. The metal field plate 152 can include multiple layers of metal or conductive material.

In one embodiment, the combination of the metal field plate 152, the floating gate 112, and the dielectric layer 150 provides a relatively high breakdown voltage. The breakdown voltage can be higher than 20 V. In one embodiment, the breakdown voltage is about 100 V in an example in which the dielectric layer 150 includes silicon oxide of about 80 nm in thickness.

In one embodiment, the metal field plate 152 enables both positive and negative polarities to be provided to the control gate of the capacitor C. This allows flexibility in designing memory array layouts and in designing read, program, and erase schemes for the nonvolatile memory cell 102. Furthermore, the memory cell 102 enables the capacitive coupling between the floating gate and the control gate to not rely solely on the thickness of the dielectric layer 150. This can be adjusted by exploiting the overlap of the floating gate and the control gate on the field oxide regions 108.

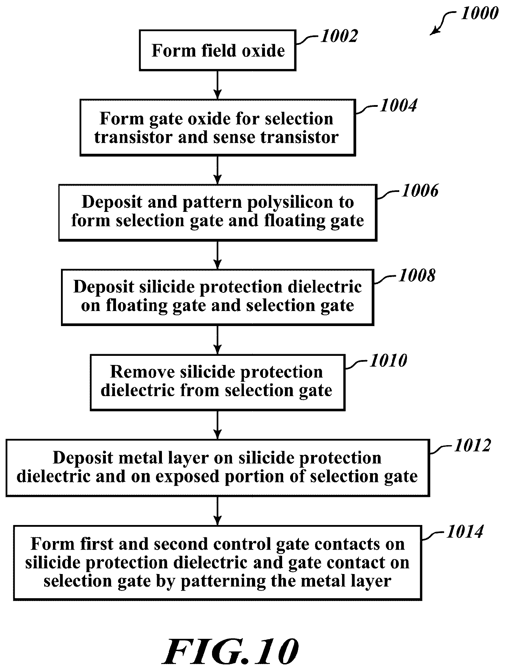

Figure 10 is a flow diagram of a method 1000 for forming a nonvolatile memory cell, in accordance with one embodiment. The method 1000 can utilize materials, components, structures, and processes described in relation to Figures 1A-9. At 1002, the method 1000 includes forming a field oxide on a substrate. One example of a field oxide is the field dielectric 108 of Figure 1A. One example of a substrate is the substrate 104 of Figure 1A.

At 1004, the method 1000 includes forming a gate oxide for a selection transistor and a floating gate transistor. One example of a floating gate transistor is the floating gate transistor T1 of Figure 1A. One example of a selection transistor is the transistor T2 of Figure 1A. One example of the gate oxide is the gate dielectric layer 110 of Figure 1A.

At 1006, the method 1000 includes depositing and patterning a layer of polysilicon to form the selection gate and the floating gate. One example of polysilicon is the polysilicon 113 of the gate terminal of the selection transistor T2 of Figure 1A and the polysilicon floating gate 112 of the floating gate transistor T1 Figure 1A.

At 1008, the method 1000 includes depositing a silicide protection dielectric layer on the floating gate and on the selection gate. One example of a silicide protection dielectric layer is the silicide protection dielectric layer 114 of Figure 1A.

At 1010, the method 1000 includes removing the silicide protection dielectric layer from the selection gate. This includes patterning the silicide protection dielectric layer to form windows that expose the polysilicon gate of the selection transistor. One example of windows are the windows 126 of Figure 7A.

At 1012, the method 1000 includes depositing a metal layer on the silicide protection dielectric layer and on the exposed portion of the polysilicon selection gate.

At 1014, the method 1000 includes forming first and second control gate contacts on the silicide protection dielectric layer and the gate contact on the selection gate by patterning the metal layer. One example of first and second control gate contacts are the control gate contacts 116a and 116b of Figure 1A. One example of a gate contact is the gate contact 118 of Figure 1A.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

The present disclosure could be exemplified by a memory device according to the following non-limiting examples 1-5.

Example 1. A memory device, comprising: a semiconductor substrate including an active region and a field region; a floating gate; a control gate above the floating gate; and a dielectric layer interposed between the control gate and the floating gate, wherein the control gate includes a plurality of discrete elements.

Example 2. The memory of example 1, wherein the plurality of discrete elements includes a first control gate contact and a second control gate contact both in direct contact with the dielectric layer.

Example 3. The memory of example 2, wherein a first area of contact of the first control gate contact and the dielectric layer at least partially overlies the field region on a first side of the active region; and a second area of contact of the second control gate ontact and the dielectric layer at least partially overlies the field region on a second side of the active region opposite the first side.

Example 4. The memory of example 3, wherein the first area of contact is laterally entirely outside the active region on the first side, wherein the second area of contact is laterally entirely outside the active region on second first side.

Example 5. The memory of example 1, wherein the dielectric layer is a silicide protection layer including a plurality of sub-layers.

The present disclosure could be also exemplified by a memory device according to the following non-limiting examples 6-8.

Example 6. A memory device, comprising: a semiconductor substrate including an active region and a field region; a floating gate overlying the active region and the field region; a control gate arranged above the floating gate; and a dielectric layer interposed between the control gate and the floating gate, wherein the control gate overlays the field region without overlapping the active region.

Example 7. The memory device of example 6, comprising a non-volatile memory cell including: a floating gate transistor including the floating gate; and a selection transistor including a gate terminal of a same material as the floating gate and positioned over the active region and the field region and including: a gate contact in direct contact with the gate terminal and overlays the field region without overlapping the active region.

Example 8. The memory device of example 7, wherein the gate contact contacts the gate terminal through an opening in the dielectric layer.

The present disclosure could be also exemplified by a manufacturing method of a memory device according to the following non limiting examples 9-12.

Example 9. A manufacturing method of a memory device, comprising: forming a floating gate of a floating gate transistor of a memory cell overlying an active region and a field region of semiconductor substrate; forming a gate terminal of a selection transistor of the memory cell overlying the active region and the field region of the semiconductor substrate, the floating gate and the gate terminal having a same material; forming a dielectric layer over the floating gate and the gate terminal; forming a window in the dielectric layer exposing the gate terminal; forming a control gate of the floating gate transistor on the dielectric layer over the floating gate; and forming a gate contact in contact with the gate terminal in the opening.

Example 10. The method of example 9, comprising: depositing a metal on the gate terminal and on the dielectric layer; and forming the gate contact and the control gate by patterning the metal.

Example 11. The method of example 9, wherein the dielectric layer includes a plurality of dielectric sub-layers.

Example 12. The method of example 9, comprising forming a silicide on the gate contact.

The present disclosure could be also exemplified by a reading method of a memory device according to the following non limiting examples 13-15.

Example 13. A method, comprising reading data from a non-volatile memory cell including a floating gate transistor including a floating gate overlying an active region and a field region of a semiconductor substrate, the reading data including: applying a read body voltage to the field region; applying a read control gate voltage to a control gate positioned on a dielectric layer, the dielectric layer positioned on the floating gate, the control gate overlying the field region; and sensing a current responsive to the read control gate voltage.

Example 14. The method of example 13, wherein reading data includes applying a selection voltage to a gate terminal of a selection transistor of the memory cell, the gate terminal overlying the active region.

Example 15. The method of example 14, comprising applying the selection voltage via a gate contact extending through an opening in the dielectric layer to contact the gate terminal.

## Claims

1. A memory device (100) comprising:
a semiconductor substrate (104) including an active region (106) and a field region (105, 108);
a floating gate (112) above the semiconductor substrate (104);
a control gate (116a, 116b; 152) above the floating gate (112); and
a dielectric layer (114; 150) interposed between the control gate (116a, 116b; 152) and the floating gate (112), wherein the control gate (116a, 116b; 152) is made at least in part of a metallic material.

2. The memory device of claim 1, comprising a non-volatile memory cell (102) including a floating gate transistor (T1) and a selection transistor (T2) each positioned over, and overlapping, the active region (106).

3. The memory device of claim 2, wherein:
the floating gate transistor (T1) includes the floating gate (112);
the selection transistor (T2) includes a gate terminal of a same material as the floating gate (112); and
wherein the dielectric layer (114; 150) includes an opening above the gate terminal.

4. The memory device of claim 3, wherein the dielectric layer (114; 150) is a silicide protection dielectric layer including a plurality of sub-layers.

5. The memory device of claim 4, wherein the sub-layers include a first sub-layer of silicon oxide, a second sub-layer of tetraethyl orthosilicate on the first sub-layer, and a third sub-layer of silicon nitride on the second sub-layer.

6. The memory device of claim 2, wherein the control gate includes:
a first control gate contact (116a) in contact with the dielectric layer (114) over the floating gate (112) and overlapping the field region (105; 108) on a first side of the active region (106); and
a second control gate contact (116b) in contact with the dielectric layer (114) over the floating gate (112) and overlapping the field region (105; 108) on a second side of the active region (106).

7. The memory device of claim 6, wherein the first control gate contact (116a) and the second control gate contact (116b) are staggered with respect to the active region.

8. The memory device of claim 6, wherein the first control gate contact (116a) forms a first capacitor area with the floating gate (112), wherein the second control gate contact (116b) forms a second capacitor area with the floating gate (112), wherein the first capacitor area is at least 10 times larger than the second capacitor area.

9. The memory device of claim 2, comprising a field dielectric (108) positioned on a first side of the active region (106) and on a second side of the active region (106) opposite the first side, wherein the control gate comprises a metal field plate (152) that continuously overlies the active region (106), the field dielectric (108) on the first side of the active region (106), and the field dielectric (108) on the second side of the active region (106).

10. The memory device of claim 9, comprising dielectric sidewall spacers (154) on sidewalls of the floating gate (112), wherein the dielectric layer (150) is in direct contact with the dielectric sidewall spacers (154).

11. The memory device of claim 2, wherein the floating gate transistor and the selection transistor each have a respective gate dielectric of a same thickness and a same material.

12. The memory device of claim 1, wherein the field region includes a P-well, wherein the active region includes an N-Well.

13. The memory device of claim 1, wherein the control gate comprises a plurality of discrete elements (116a, 116b) in direct contact with the dielectric layer (114), wherein a first discrete element (116a) at least partially overlies the field region (105; 108) on a first side of the active region (106); and a second discrete element (116b) at least partially overlies the field region (105; 108) on a second side of the active region (106) opposite the first side, and wherein the plurality of discrete elements (116a, 116b) are entirely outside of the active region (106).

14. The memory device of claim 1, wherein the control gate comprises a single element (152) in contact with the dielectric layer (150), the single element (152) extending continuously over the active region (106) and the field region (105; 108).

15. The memory device of claim 14, wherein the single element (152) completely covers the floating gate (112).
